# EUROPÄISCHE PATENTSCHRIFT

(11) **EP 0 933 708 B1**
(45) Veröffentlichungstag und Bekanntmachung des Hinweises auf die Patenterteilung: **20.08.2003**
(21) Anmeldenummer: 99101470.5
(22) Anmeldetag: 27.01.1999
(51) Int. Cl.: G06F 11/10

(54) **Integrierter Speicher mit Fehlerkorrekturdaten in einer Betriebsart**
Integrated storage featuring error correcting data in one operating mode
Mémoire intégrée comportant des données de correction d'erreurs dans un mode de fonctionnement

(30) Priorität: 02.02.1998 DE 19804035
(43) Veröffentlichungstag der Anmeldung: 04.08.1999
(73) Patentinhaber: Infineon Technologies AG, 81669 München (DE)
(72) Erfinder: McConnel, Roderick, Dr., 81541 München (DE); Richter, Detlev, 81827 München (DE)
(74) Vertreter: Beck, Josef

(56) Entgegenhaltungen:
- EP-A- 0 184 737
- US-A- 4 528 666
- US-A- 5 493 574
- HIDETO HIDAKA ET AL: "THE CACHE DRAM ARCHITECTURE: A DRAM WITH AN ON-CHIP CACHE MEMORY" IEEE MICRO, Bd. 10, Nr. 2, 1. April 1990 (1990-04-01), Seiten 14-25, XP000116649 ISSN: 0272-1732

## Beschreibung

Die Erfindung betrifft einen integrierten Speicher mit einer Fehlerkorrekturfunktion.

Eine Fehlerkorrekturfunktion für integrierte Speicher (wie z.B. Dynamische Speicher, DRAMs) wird mit sogenannten Fehlerkorrekturcodes (Error Correction Codes ECC) realisiert. Im einfachsten Fall wird ein sogenannter Parity Check durchgeführt. Das bedeutet, daß zu jedem zu speichernden Datenwort, das aus mehreren Bits besteht, ein oder mehrere Paritätsbits erzeugt und mit dem Datenwort gemeinsam im Speicher gespeichert werden. Beim Auslesen des Datenwortes aus dem Speicher werden die mit ihm abgespeicherten Paritätsbits ausgewertet, wodurch je nach Anzahl der Paritätsbits ein oder mehrere Bitfehler detektierbar und je nach eingesetztem Fehlerkorrekturcode auch korrigierbar sind. Ein einfacher und weit verbreiteter Fehlerkorrekturcode ist der Hamming Code. Speicher, die mit einer derartigen Fehlerkorrekturfunktion ausgerüstet sind, benötigen zum Speichern der Paritätsbits zusätzlichen Speicherplatz.

Es existieren also zwei Arten von Speichern: Zum einen Speicher, bei denen keine Fehlerkorrekturfunktion vorgesehen ist, und bei denen demnach der Speicherbedarf pro Datenwort genau der Anzahl der Bits pro Datenwort entspricht, und zum anderen Speicher mit Fehlerkorrekturfunktion, die einen um die Paritätsbits erhöhten Speicherbedarf pro Datenwort haben, jedoch es ermöglichen, beim Speichern auftretende Fehler zu korrigieren. Die erstgenannten Speicher eignen sich zum Speichern von fehlerunempfindlichen Nutzdaten, wie z.B. Audiodaten. Die letztgenannten Speicher eignen sich für Anwendungen, bei denen die Fehlerfreiheit eine große Rolle spielt, wie dies zum Beispiel bei Programmspeichern der Fall ist.

Die Druckschrift US 4 528 666 beschreibt einen integrierten Speicher mit einem ersten Speicherbereich, der zum Speichern von Nutzdaten dient, und mit einem zweiten Speicherbereich , der zum Speichern von Fehlerkorrekturdaten für die im ersten Speicherbereich zu speichernden Nutzdaten dient. Ferner ist eine Fehlerkorrektureinheit zur Erzeugung und Auswertung der im zweiten Speicherbereich gespeicherten Fehlerkorrekturdaten vorgesehen.

Der Erfindung liegt die Aufgabe zugrunde, einen integrierten Speicher anzugeben, der eine Fehlerkorrekturfunktion aufweist jedoch und für das Speichern fehlerempfindlicher und fehlerunempfindlicher Daten optimierbar ist.

Diese Aufgabe wird mit einem integrierten Speicher gemäß Anspruch 1 gelöst. Vorteilhafte Aus- und Weiterbildungen der Erfindung sind Gegenstand von abhängigen Ansprüchen.

Der integrierte Speicher weist zwei Betriebsarten und wenigstens zwei Speicherbereiche auf. Der erste Speicherbereich dient in beiden Betriebsarten zum Speichern von Nutzdaten. Nutzdaten sind die zu speichernden Bits eines Datenwortes ohne zusätzliche Fehlerkorrekturbits bzw. Paritätsbits. Der zweite Speicherbereich dient in der ersten, aber nicht in der zweiten Betriebsart zum Speichern von Fehlerkorrekturdaten für im ersten Speicherbereich zu speichernde Nutzdaten. Der Speicher hat also in der ersten Betriebsart eine Fehlerkorrekturfunktion, die den im ersten Speicherbereich zu speichernden Nutzdaten im zweiten Speicherbereich zu speichernde Fehlerkorrekturdaten (Fehlerkorrekturbits bzw. Paritätsbits) zuordnet, und eine zweite Betriebsart, in der die Nutzdaten im ersten Speicherbereich gespeichert werden, ohne daß zusätzliche Fehlerkorrekturdaten im zweiten Speicherbereich abgelegt werden.

In der zweiten Betriebsart ist die Fehlerkorrekturfunktion des Speichers also deaktiviert. Somit eignet sich der Speicher in der ersten Betriebsart zum Speichern von Nutzdaten, bei denen es auf eine hohe Fehlersicherheit ankommt, wie dies beispielsweise bei Programmdaten der Fall ist. In der zweiten Betriebsart eignet sich der Speicher vorzugsweise für solche Daten, bei denen es auf eine hohe Fehlersicherheit nicht ankommt, wie dies beispielsweise bei Audio-Daten der Fall ist. Der zweite Speicherbereich ist günstigerweise so zu dimensionieren, daß er in der ersten Betriebsart alle den Nutzdaten des ersten Speicherbereichs zugeordnete Fehlerkorrekturdaten aufnehmen kann. Der zweite Speicherbereich wird daher in der Regel kleiner als der erste Speicherbereich sein.

Der erfindungsgemäße integrierte Speicher kann beispielsweise ein DRAM, ein SRAM, ein EPROM oder jede beliebige andere Art von integriertem Speicher sein.

Der Speicher weist auch eine Fehlerkorrektureinheit auf, die zur Erzeugung und Auswertung der im zweiten Speicherbereich zu speichernden Fehlerkorrekturdaten dient. Die Fehlerkorrektureinheit ist nur in der ersten, aber nicht in der zweiten Betriebsart aktiviert. Das bedeutet, daß die Fehlerkorrektureinheit die Fehlerkorrekturfunktion ausschließlich in der ersten Betriebsart durchführt.

Nach einer ersten Ausführungsform der Erfindung ist die zweite Betriebsart eine Energiesparbetriebsart, in der der zweite Speicherbereich deaktiviert ist. Dabei bedeutet "deaktiviert", daß die Stromaufnahme des zweiten Speicherbereiches reduziert oder sogar gleich Null ist. Eine solche Deaktivierung ist möglich, da der zweite Speicherbereich in der zweiten Betriebsart nicht zum Speichern von Fehlerkorrekturdaten benötigt wird. Ein solcher Speicher eignet sich in der zweiten Betriebsart zum Speichern von nicht fehlerempfindlichen Daten bei gleichzeitiger geringerer Stromaufnahme als in der ersten Betriebsart. Herkömmliche Speicher weisen entweder überhaupt keine Fehlerkorrekturfunktion auf und sind damit für das Speichern von fehlerempfindlichen Daten unbrauchbar, oder aber sie haben eine ständig aktivierte Fehlerkorrekturfunktion, so daß ihre Stromaufnahme auch beim Speichern von nicht fehlerempfindlichen Daten, die eine Fehlerkorrektur nicht benötigen, relativ hoch ist.

Nach einer zweiten Ausführungsform, die nicht durch die anhängenden Ansprüche gedeckt ist, dient der zweite Speicherbereich in der zweiten Betriebsart, in der er keine Fehlerkorrekturdaten speichert, zum Speichern von Nutzdaten. Das heißt, in der zweiten Betriebsart können Nutzdaten sowohl im ersten als auch im zweiten Speicherbereich gespeichert werden. In der zweiten Betriebsart steht also eine größere Speicherkapazität zur Verfügung als in der ersten Betriebsart. Somit können in der zweiten Betriebsart mehr Nutzdaten im Speicher gespeichert werden als in der ersten Betriebsart, sofern es sich um fehlerunempfindliche Daten handelt. Bei herkömmlichen Speichern mit oder ohne Fehlerkorrekturfunktion ist die Speicherkapazität immer dieselbe, egal, ob fehlerempfindliche oder fehlerunempfindliche Daten zu speichern sind.

Der erfindungsgemäße Speicher bietet also je nach Ausführungsform die Möglichkeit, in Abhängigkeit von der Art der zu speichernden Daten bzw. der erwünschten Fehlersicherheit entweder die Stromaufnahme des Speichers zu verändern oder eine unterschiedlich große Speicherkapazität zur Verfügung zu haben.

Die beiden Speicherbereiche können entweder räumlich voneinander getrennt sein, indem sie beispielsweise Bestandteile unterschiedlicher Speicherzellenfelder oder Speicherblöcke sind, oder sie können innerhalb desselben Speicherzellenfeldes oder Speicherblockes ineinander verschachtelt angeordnet sein.

Nach einer Weiterbildung weist der Speicher eine Prüfeinheit zum Prüfen des ersten Speicherbereiches auf Speicherfehler auf und zur Festlegung der Betriebsart des Speichers in Abhängigkeit des Prüfergebnisses. Die Prüfeinheit kann beispielsweise während des Betriebes des Speichers den ersten Speicherbereich prüfen und die Fehlerkorrekturfunktion durch einen Wechsel von der zweiten in die erste Betriebsart nur dann bewirken, wenn tatsächlich Speicherfehler auftreten. Dies hat den Vorteil, daß ohne Vorhandensein von Speicherfehlern der Speicher in der zweiten Betriebsart betrieben wird, in der, wie erläutert, beispielsweise die Energieaufnahme geringer als in der ersten Betriebsart sein kann.

Alternativ kann ein Wechsel zwischen den Betriebsarten auch über ein dem Speicher von extern zugeführtes Steuersignal erfolgen. Der Benutzer des Speichers kann die Betriebsart dann nach seinem Bedarf wählen.

Die Erfindung ermöglicht durch das Ein- und Ausschalten der Fehlerkorrekturfunktion, die z.B. auch getrennt für jeden der ersten Speicherbereiche erfolgen kann, den flexiblen Einsatz des Speichers für verschiedene Anwendungen. So kann die Fehlerkorrekturfunktion für diejenigen ersten Speicherbereiche ausgeschaltet werden, in denen lediglich fehlerunempfindliche Nutzdaten wie beispielsweise Audio-Daten zu speichern sind, während die Fehlerkorrekturfunktion für solche ersten Speicherbereiche aktiviert werden muß, in denen fehlerempfindliche Nutzdaten wie beispielsweise Programmdaten zu speichern sind.

Bisher war es erforderlich, Speicher, die sowohl zum Speichern von fehlerempfindlichen als auch zum Speichern von fehlerunempfindlichen Daten vorgesehen sind, die aber keine Fehlerkorrekturfunktion aufweisen, in einem aufwendigen und langwierigen Testverfahren auf Fehlerfreiheit sowohl für harte Speicherfehler (hard errors, Hardwarefehler) als auch für weiche Speicherfehler (soft errors, treten nicht bei jedem Speicherzugriff auf) zu testen. Der Aufwand zum Testen von soft errors ist wesentlich größer als derjenige zum Testen von hard errors. Die Erfindung ermöglicht es, den Speicher im Anschluß an die Herstellung nur einem kurzen Test auf harte Speicherfehler zu unterziehen, so daß bis zu 80% der Testzeit und Testkosten eingespart werden können. Soll der Speicher dann später zum Speichern fehlerempfindlicher Daten eingesetzt werden, wird er in die erste Betriebsart versetzt. Soll er nur zum Speichern von fehlerunempfindlichen Daten dienen, sind weiche Fehler tolerierbar und der Speicher kann in der zweiten Betriebsart betrieben werden. Dabei kann der Anwender des Speichers selbst bestimmen, in welcher Betriebsart dieser betrieben werden soll. Außerdem kann vorgesehen sein, daß die Betriebsart während des Betriebes des Speichers gewechselt wird, je nachdem, welche Art von Daten gerade zu speichern ist.

Die Erfindung wird im folgenden anhand der Figuren näher erläutert, die Ausführungsbeispiele darstellen. Es zeigen:
- Figur 1: ein erstes Ausführungsbeispiel des integrierten Speichers mit einer Energiesparbetriebsart und
- Figur 2: ein zweites Ausführungsbeispiel, das nicht durch die anhängenden Ansprüche gedeckt ist, bei dem die Speicherkapazität des Speichers in zwei Betriebsarten jeweils unterschiedlich ist.

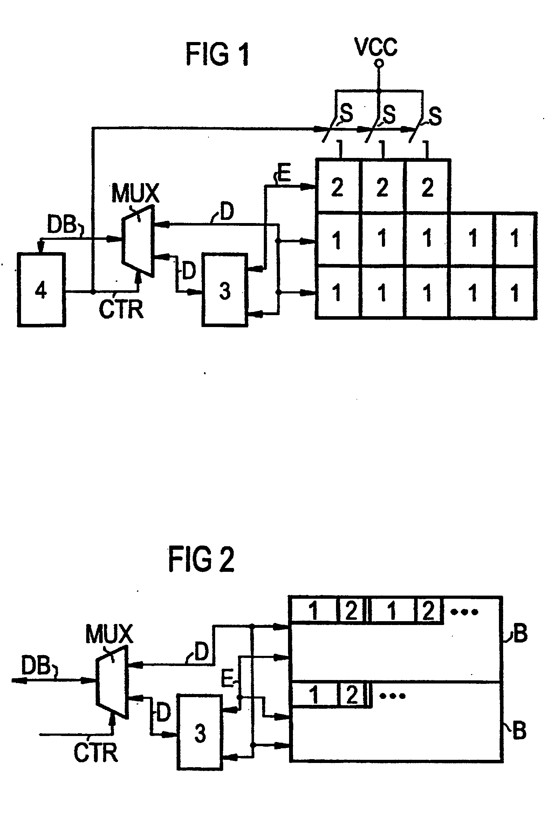

Figur 1 zeigt ein erstes Ausführungsbeispiel des erfindungsgemäßen integrierten Speichers, der ein DRAM ist und erste Speicherbereiche 1 und zweite Speicherbereiche 2 in Form von Speicherblöcken aufweist. Die ersten Speicherbereiche 1 dienen sowohl in einer ersten als auch in einer zweiten Betriebsart des Speichers dem Speichern von über einen Datenbus DB von einem Prozessor 4 übertragenen Nutzdaten. Die zweiten Speicherbereiche 2 dienen nur in der ersten Betriebsart dem Speichern von den in den ersten Speicherbereichen 1 gespeicherten Nutzdaten zugeordneten Fehlerkorrekturdaten. In der zweiten Betriebsart dienen die zweiten Speicherbereiche 2 nicht dem Speichern von Fehlerkorrekturdaten, sondern werden deaktiviert. Durch öffnen von mit einem Versorgungspotential VCC des Speichers verbundenen Schaltern S werden die zweiten Speicherbereiche 2 in der zweiten Betriebsart vom Versorgungspotential VCC getrennt, so daß ihre Stromaufnahme anschließend gleich Null ist. Bei der zweiten Betriebsart handelt es sich also um eine Energiesparbetriebsart dieses Ausführungsbeispiels der Erfindung.

Bei anderen Ausführungsformen muß in der Energiesparbetriebsart kein Trennen des zweiten Speicherbereiches von der Versorgungsspannung erfolgen. Stattdessen kann bei einem DRAM beispielsweise das Auffrischen der Speicherzelleninhalte (Refresh) in der zweiten Betriebsart unterbunden sein. Auch hierdurch wird der Stromverbrauch gesenkt.

Jeder der Speicherbereiche 1, 2 weist eine Vielzahl von Speicherzellen zum Speichern je eines Bits der Nutz- bzw. Fehlerkorrekturdaten auf. Die Speicherzellen des Speichers sind matrixförmig angeordnet und werden über eine in Figur 1 nicht dargestellte Zeilen- bzw. Spaltendecodierung, wie bei herkömmlichen Speichern üblich, adressiert.

Der Speicher in Figur 1 weist weiterhin eine Fehlerkorrektureinheit 3 zur Erzeugung der in der ersten Betriebsart in den zweiten Speicherbereichen 2 zu speichernden Fehlerkorrekturdaten und zur Auswertung dieser Fehlerkorrekturdaten beim Auslesen der entsprechenden Nutzdaten aus den ersten Speicherbereichen 1 auf. In der ersten Betriebsart empfängt die Fehlerkorrektureinheit 3 über einen Multiplexer MUX auf dem Datenbus DB liegende Nutzdaten D, erzeugt dazugehörige Fehlerkorrekturdaten E mittels eines geeigneten Fehlerkorrekturcodes (wie z.B. dem Hamming Code) und schreibt diese Fehlerkorrekturdaten E in einen der zweiten Speicherbereiche 2 und die dazugehörigen Nutzdaten D in einen der ersten Speicherbereiche 1. Beim Auslesen von Nutzdaten D aus einem der ersten Speicherbereiche liest die Fehlerkorrektureinheit 3 gleichzeitig die diesen Nutzdaten D zugeordneten Fehlerkorrekturdaten E aus dem entsprechenden zweiten Speicherbereich 2. Anschließend führt sie anhand der Fehlerkorrekturdaten E eine Überprüfung der Nutzdaten D auf Bitfehler durch und korrigiert diese gegebenenfalls. Daraufhin gibt sie die (ggf. korrigierten) Nutzdaten D über den Multiplexer MUX auf den Datenbus DB.

In der zweiten Betriebsart sind die zweiten Speicherbereiche 2 deaktiviert und die Nutzdaten D werden direkt vom Datenbus DB über den Multiplexer MUX in einen der ersten Speicherbereiche 1 geschrieben, wobei die Fehlerkorrektureinheit 3 umgangen wird. Sie wird in der zweiten Betriebsart auch beim Auslesen dieser Nutzdaten aus den ersten Speicherbereichen 1 umgangen. Die Fehlerkorrektureinheit 3 ist somit nur in der ersten Betriebsart aktiviert und in der zweiten Betriebsart deaktiviert.

Beim gezeigten Ausführungsbeispiel werden die Nutzdaten D über den Datenbus DB zwischen dem Prozessor 4 und dem Multiplexer MUX übertragen. Dabei kann der Prozessor 4 entweder Bestandteil derselben integrierten Schaltung wie die bereits erläuterten Komponenten sein oder kann auf einer davon getrennten integrierten Schaltung angeordnet sein. Der Prozessor 4 ist mit dem Multiplexer MUX sowie den Schaltern S über eine Steuerleitung CTR verbunden. Über diese steuert der Prozessor 4, in welcher Betriebsart sich der Speicher befindet. Hat die Steuerleitung CTR ein hohes Potential, befindet sich der Speicher in der ersten Betriebsart, die Schalter S sind geschlossen und der Multiplexer MUX überträgt Nutzdaten D über die Fehlerkorrektureinheit 3 von und zu den ersten Speicherbereichen 1, während die Fehlerkorrektureinheit die Fehlerkorrekturdaten E von und zu den zweiten Speicherbereichen 2 überträgt. In der zweiten Betriebsart hat die Steuerleitung CTR ein niedriges Potential, die Schalter S sind geöffnet und der Multiplexer MUX überträgt die Nutzdaten D von und zu den ersten Speicherbereichen 1 unter Umgehung der Fehlerkorrektureinheit 3. Letztere überträgt in der zweiten Betriebsart keine Fehlerkorrekturdaten E von und zu den zweiten Speicherbereichen.

Beim dargestellten Ausführungsbeispiel ist es vorgesehen, daß der Prozessor 4 den Speicher zunächst in der zweiten Betriebsart mit der geringen Stromaufnahme betreibt und daß er in regelmäßigen Abständen einen Speichertest der ersten Speicherbereiche 1 durchführt. Der Speichertest erfolgt durch Einschreiben von Testdaten und nachfolgendes Auslesen in die ersten Speicherbereiche 1, wobei die ausgelesenen Testdaten mit den eingeschriebenen verglichen werden. Stellt der Prozessor 4 dabei Speicherfehler fest, versetzt er den Speicher über die Steuerleitung CTR von der zweiten in die erste Betriebsart, wodurch die zweiten Speicherbereiche 2 und die Fehlerkorrekturfunktion aktiviert werden. Der Prozessor 4 hat dabei die Funktion einer Prüfeinheit.

Bei anderen Ausführungsformen der Erfindung entfällt die soeben geschilderte Funktion der Prüfeinheit und die Betriebsart wird (ggf. durch den Nutzer des Speichers) in Abhängigkeit der Fehlerempfindlichkeit der zu speichernden Daten festgelegt. Die Steuerleitung CTR kann zu diesem Zweck dem Speicher z.B. auch unter Umgehung des Prozessors 4 zugeführt werden. Über die Steuerleitung kann die gewünschte Betriebsart dann von extern eingestellt werden.

Figur 2 zeigt ein zweites Beispiel des integrierten Speichers, das sich vom Ausführungsbeispiel in Figur 1 darin unterscheidet, daß die ersten 1 und zweiten 2 Speicherbereiche nicht mehr räumlich voneinander getrennt, sondern ineinander verschachtelt innerhalb von Speicherblöcken B angeordnet sind. Das heißt, in der ersten Betriebsart sind die in den ersten Speicherbereichen 1 zu speichernden Nutzdaten direkt den ihnen zugeordneten Fehlerkorrekturdaten in den zweiten Speicherbereichen 2 benachbart. Bei diesem Beispiel weist der Datenbus DB eine Breite von 40 Bit auf, von denen in der ersten Betriebsart aber nur 32 Bit genutzt werden. Jeder der ersten Speicherbereiche 1 kann ein Datenwort von Nutzdaten mit 32 Bit aufnehmen. Jeder der zweiten Speicherbereiche 2 kann 8 Bit Fehlerkorrekturdaten aufnehmen. Zum Speichern von 32 Bit Nutzdaten werden also in der ersten Betriebsart 40 Bit Speicherplatz benötigt. In der zweiten Betriebsart, die bei diesem Beispiel, anders als bei demjenigen aus Figur 1 keine Energiesparbetriebsart ist, werden auch die zweiten Speicherbereiche 2 zum Speichern von Nutzdaten eingesetzt. Es können dann Datenworte mit einer Breite von 40 Bit über den Datenbus DB in den Speicher eingeschrieben und aus diesem ausgelesen werden. Der Datenbus DB und die internen Datenbusse weisen daher 40 Leitungen auf, von denen in der ersten Betriebsart lediglich 32 genutzt werden.

Bei einer Abwandlung des Beispiels aus Figur 2 kann auch vorgesehen sein, daß in der zweiten Betriebsart lediglich 32 Bit Worte von Nutzdaten gespeichert und wieder ausgelesen werden. Bei diesen Worten ist diejenige Speicherzelle, in der das jeweils erste Bit des Datenwortes gespeichert ist, in der zweiten Betriebsart gegenüber der ersten Betriebsart verschoben. Der Datenbus DB und die externen Busse sind dann lediglich 32 Bit breit. Es kann dann eine größere Anzahl von Datenworten von jeweils 32 Bit Breite gespeichert werden. Beim Beispiel nach Figur 2 bleibt die Anzahl der Datenworte dagegen konstant, jedoch ist die Datenwortbreite in der zweiten Betriebsart größer als in der ersten Betriebsart.

Bei einem anderen Ausführungsbeispiel der Erfindung kann es vorgesehen sein, bei einer verschachtelten Anordnung der ersten und zweiten Speicherbereiche 1, 2 (entsprechend Figur 2) ebenso eine Deaktivierung der zweiten Speicherbereiche 2 vorzunehmen, wie dies anhand von Figur 1 erläutert worden ist. Außerdem ist es möglich, bei einer räumlich getrennten Anordnung der ersten und zweiten Speicherbereiche (entsprechend Figur 1) statt der energiesparenden Deaktivierung der zweiten Speicherbereiche 2 in der zweiten Betriebsart diese zum Speichern von Nutzdaten zu verwenden, wie dies anhand von Figur 2 erläutert worden ist. Da die in Figur 1 dargestellten ersten und zweiten Speicherbereiche jeweils Speicherblöcke derselben Speicherkapazität darstellen, ergäbe sich bei zehn ersten Speicherbereichen 1 und drei zweiten Speicherbereichen 2 eine Erhöhung der für Nutzdaten zur Verfügung stehenden Speicherkapazität in der zweiten Betriebsart um 30% gegenüber der ersten Betriebsart.

## Patentansprüche

1. Integrierter Speicher
- mit einer ersten und einer zweiten Betriebsart,
- mit wenigstens einem ersten Speicherbereich (1), der in beiden Betriebsarten zum Speichern von Nutzdaten dient,
- mit wenigstens einem zweiten Speicherbereich (2), der in der ersten Betriebsart zum Speichern von Fehlerkorrekturdaten für im ersten Speicherbereich zu speichernde Nutzdaten dient.
- und mit einer Fehlerkorrektureinheit (3) zur Erzeugung und Auswertung der im zweiten Speicherbereich (2) zu speichernden Fehlerkorrekturdaten, die in der ersten Betriebsart aktiviert ist,
**dadurch gekennzeichnet, dass** die zweite Betriebsart des Speichers eine Energiesparbetriebsart ist, in der der zweite Speicherbereich (2) deaktiviert ist, so dass die Stromaufnahme des zweiten Speicherbereichs reduziert oder gleich Null ist.

2. Speicher nach Anspruch 1, dessen erster (1) und zweiter (2) Speicherbereich räumlich voneinander getrennt sind.

3. Speicher nach einen der Ansprüche 1 oder 2, dessen erster (1) und zweiter (2) Speicherbereich ineinander verschachtelt angeordnet sind.

4. Speicher nach einem der Ansprüche 1 bis 3, mit einer Prüfeinheit (4) zum Prüfen des ersten Speicherbereiches (1) auf Speicherfehler und zur Festlegung der Betriebsart des Speichers in Abhängigkeit des Prüfergebnisses.

5. Speicher nach einem der Ansprüche 1 bis 4,
der einen Anschluß zum Anlegen eines Steuersignals (CTR) hat, in dessen Abhängigkeit ein Wechsel zwischen den Betriebsarten erfolgt.

6. Verfahren zum Speichern von Daten in einem Speicher nach einem der vorhergehenden Ansprüche,
**dadurch gekennzeichnet, dass** das Speichern von Daten in der ersten Betriebsart durchgeführt wird, wenn die zu speichernden Daten fehlerempfindlich sind und das Speichern von Daten in der zweiten Betriebsart durchgeführt wird, wenn die Daten fehlerunempfindlich sind.

7. Verfahren nach Anspruch 6,
**dadurch gekennzeichnet, dass** fehlerunempfindliche Daten Klangdaten und/oder dass fehlerempfindliche Daten Programmdaten sind.

## Claims

1. Integrated memory
- having a first and a second mode of operation,
- having at least one first memory area (1), which is used to store useful data in both modes of operation,
- having at least one second memory area (2), which is used in the first mode of operation to store error correction data for useful data which are to be stored in the first memory area, and
- having an error correction unit (3) for producing and evaluating the error correction data which are to be stored in the second memory area (2), this error correction unit (3) being activated in the first mode of operation, **characterized in that** the second mode of operation of the memory is an energy-saving mode of operation in which the second memory area (2) is deactivated, so that the power consumption of the second memory area is reduced or is equal to zero.

2. Memory according to Claim 1, whose first (1) and second (2) memory areas are spatially separate from one another.

3. Memory according to either of Claims 1 and 2, whose first (1) and second (2) memory areas are in a concatenated arrangement.

4. Memory according to one of Claims 1 to 3, having a test unit (4) to test the first memory area (1) for storage errors, and to define the mode of operation of the memory depending on the test result.

5. Memory according to one of Claims 1 to 4, having a connection for applying a control signal (CTR) depending on which a changeover between the operating modes occurs.

6. Method for storing data in a memory according to one of the preceding claims,
**characterized in that** data are stored in the first mode of operation if the data to be stored are sensitive to error, and data are stored in the second mode of operation if the data are insensitive to error.

7. Method according to Claim 6,
**characterized in that** data which are insensitive to error are tone data and/or **in that** data which are sensitive to error are program data.

## Revendications

1. Mémoire intégrée
- ayant un premier et un deuxième type de fonctionnement,
- ayant au moins une première zone (1) de mémoire, qui sert dans les deux types de fonctionnement à mémoriser des données utiles,
- ayant au moins une deuxième zone (2) de mémoire, qui sert dans le premier type de fonctionnement à mémoriser des données de correction d'erreurs pour des données utiles à mémoriser dans la première zone de mémoire,
- et ayant une unité (3) de correction d'erreurs pour produire et exploiter les données de correction d'erreurs à mémoriser dans la deuxième zone de mémoire qui est activée dans le premier type de fonctionnement,
**caractérisée en ce que** le deuxième type de fonctionnement de la mémoire est un type de fonctionnement économisant de l'énergie, dans lequel la deuxième zone (2) de mémoire est désactivée, de sorte que l'absorption de courant de la deuxième zone de mémoire est réduite ou est égale à zéro.

2. Mémoire suivant la revendication 1,
dont la première (1) et la deuxième (2) zone de mémoire sont séparées l'une de l'autre dans l'espace.

3. Mémoire suivant l'une des revendications 1 ou 2,
dont la première (1) et la deuxième (2) zone de mémoire sont emboîtées l'une dans l'autre.

4. Mémoire suivant l'une des revendications 1 à 3,
comprenant une unité (4) de contrôle d'erreurs de mémoire de la première zone (1) de mémoire et de fixation du type de fonctionnement de la mémoire en fonction du résultat du contrôle.

5. Mémoire suivant l'une des revendications 1 à 4,
qui a une forme d'application d'un signal (CTR) de commande en fonction duquel il s'effectue un passage d'un type de fonctionnement à l'autre.

6. Procédé de mémorisation de données dans une mémoire suivant l'une des revendications précédentes,
**caractérisé en ce que** l'on effectue la mémorisation de données dans le premier type de fonctionnement si les données à mémoriser sont sujettes à l'erreur et on effectue la mémorisation de données dans le deuxième type de fonctionnement lorsque les données ne sont pas sujettes à l'erreur.

7. Procédé suivant la revendication 6,
**caractérisé en ce que** les données qui ne sont pas sujettes à l'erreur sont des données sonores et/ou les données sujettes à l'erreur sont des données de programme.
